# EUROPEAN PATENT SPECIFICATION

(11) **EP 4 474 927 B1**
(45) Date of publication and mention of the grant of the patent: **15.07.2026**
(21) Application number: 24179533.5
(22) Date of filing: 03.06.2024
(51) Int. Cl.: G05B 19/406, G05B 19/4155

(54) **MACHINE TOOL AND METHOD FOR CALCULATING POWER SAVING OF MACHINE TOOL**
WERKZEUGMASCHINE UND VERFAHREN ZUR BERECHNUNG DER ENERGIEEINSPARUNG EINER WERKZEUGMASCHINE
MACHINE-OUTIL ET PROCÉDÉ DE CALCUL D'ÉCONOMIE D'ÉNERGIE DE MACHINE-OUTIL

(30) Priority: 05.06.2023 JP 2023092201
(43) Date of publication of application: 11.12.2024
(73) Proprietor: Star Micronics Co., Ltd., Shizuoka-shi, Shizuoka 422-8654 (JP)
(72) Inventor: Saito, Hiroki, Shizuoka-shi, Shizuoka (JP); Shigama, Koichiro, Shizuoka-shi, Shizuoka (JP)
(74) Representative: Grünecker Patent- und Rechtsanwälte PartG mbB

(56) References cited:
- US-A1- 2010 026 102
- US-A1- 2013 184 893
- US-A1- 2014 180 466
- US-A1- 2017 308 059

## Description

### BACKGROUND OF THE INVENTION

### 1. Field of the Invention

The present invention relates to a machine tool having a plurality of electric devices that consume power while energized, and a method for calculating a power saving of a machine tool.

### 2. Description of the Related Art

A machine tool includes various electric devices, such as servo motors for respectively moving a front headstock, a front tool post, a back headstock, and a back tool post, as well as a coolant pump, a cooling fan, a product conveyor, and lighting equipment. These electric devices may be energized so as to consume power not only when operative but also when stopped. Operations of these electric devices are controlled mainly by a numerical control (NC) apparatus and a programmable logic controller (PLC) provided in the NC apparatus. Incidentally, in recent years there has been increasing demand for reductions in the power consumption of the electric devices as part of measures to combat global warming and soaring fuel prices. In response thereto, a machine tool that aims to reduce power consumption by shutting off energization of the electric devices that do not need to be operated has been proposed (for example, see Japanese Patent No. 5846607). Further relevant prior art is described in US 2010/026102 A1, US 2017/308059 A1 and US 2014/180466 A1.

### SUMMARY OF THE INVENTION

With the machine tool described in Japanese Patent No. 5846607, however, a problem exists in that it is impossible to know how much power was saved by shutting off energization of the electric devices. As a method for solving this problem, the difference between the power consumption of the machine tool when operated without shutting off energization and the power consumption when energization of the electric devices that do not need to be operated is shut off may be calculated as the power saving. With this method, however, the operation performed without shutting off energization and the operation performed with energization shut off are not always executed under identical conditions, causing a problem in that it is impossible to know whether the correct power saving has been calculated. Moreover, since the machine tool must be operated in a state where energization is not shut off in order to measure the power consumption thereof, another problem arises in that the operation for calculating the power saving is complicated. In order to solve these problems, it is desirable to develop a technique with which the power saving of a machine tool can be calculated easily and accurately.

The present invention has been designed in consideration of the problems described above, and an object thereof is to provide a machine tool and a method for calculating a power saving of a machine tool, with which the power saving can be calculated accurately and easily. In particular a machine tool having the features defined in claim 1 is provided. Further, a method is provided having the features defined in claim 11. Further preferred embodiments are defined in the dependent claims.

A machine tool of the present invention for solving the problems described above is a machine tool having a plurality of electric devices that consume power while energized, the machine tool including: an energization signal switching unit for switching an energization signal set for each of the electric devices between an energization required state in which energization of the electric device is required, and an energization non-required state in which energization is not required; a prohibition signal switching unit for switching an energization prohibition signal set for each of the electric devices between a prohibited state in which energization of the electric device is prohibited, and a permitted state in which energization is permitted; a signal determination unit that determines whether or not each of the electric devices is in a power saving state in which the energization signal for the electric device is in the energization required state and the energization prohibition signal is in the prohibited state; and a saving calculation unit that determines a cumulative duration of the power saving state, computes a device-specific power saving for each of the electric devices on the basis of the cumulative duration, and calculates a power saving by adding together the device-specific power savings.

According to this machine tool, the device-specific power saving is computed on the basis of the cumulative duration, and the power saving is calculated by adding together the device-specific power savings, and therefore the power saving can be calculated accurately. Moreover, there is no need to operate the machine tool in a state where energization of the electric devices is not prohibited (shut off) in order to calculate the power saving, and therefore the power saving can be calculated easily.

Here, the machine tool may include an ECO mode for reducing the power consumption of the electric devices, and it may be possible to switch between the ECO mode and a normal mode in which the power consumption of the electric devices is not reduced. The saving calculation unit may calculate the power saving in the ECO mode. The prohibition signal switching unit may switch the energization prohibition signal to the prohibited state on at least the condition that the electric device is a power saving target. Further, the prohibition signal switching unit may switch the energization prohibition signal for the electric device associated with a predetermined command to the prohibited state for a predetermined period during which a processing state realized by the predetermined command is continuously established. Furthermore, when the electric device is not the power saving target, the energization signal switching unit may switch the energization signal to the energization required state when processing for energizing the electric device is executed.

In this machine tool, the signal determination unit may determine whether or not the power saving state is established for each of the electric devices by monitoring the energization signal and the energization prohibition signal.

Thus, the signal determination unit can accurately determine whether or not the power saving state is established.

Here, the signal determination unit may monitor the energization signal and the energization prohibition signal at predetermined time intervals. Alternatively, the signal determination unit may monitor the energization signal and the energization prohibition signal constantly.

In this machine tool, the prohibition signal switching unit may set the energization prohibition signal in the prohibited state in relation to the electric device associated with a predetermined macro program on condition that the predetermined macro program is currently underway.

Thus, the power consumption of the electric devices that do not need to be energized during execution of the macro program can be reduced.

This machine tool may include a motor serving as the electric device, and the prohibition signal switching unit may switch the energization prohibition signal to the prohibited state, in which energization for exciting the motor is prohibited, on condition that the motor is not rotating.

Thus, unnecessary excitation of the motor can be prohibited, and as a result, the power consumption of the motor can be reduced.

In this machine tool, the prohibition signal switching unit may switch the energization prohibition signal for the electric device to the prohibited state on condition that a product discharge operation is currently underway or a tool other than a rotary tool has been selected.

Thus, the power consumption of the electric devices that are not required for the product discharge operation and the power consumption of the electric devices that do not need to be energized when a tool other than the rotary tool is selected can be reduced.

This machine tool may include a spindle having a chuck for gripping a workpiece, and a spindle motor that serves as the electric device for rotating the spindle, and the prohibition signal switching unit may switch the energization prohibition signal for the spindle motor to the prohibited state on condition that the spindle is positioned in a predetermined position or the chuck is open.

Thus, the power consumption of the spindle motor can be reduced.

This machine tool may include a power consumption storage unit that stores, for each of the electric devices, an average power consumption per unit time while the electric device is energized, and the saving calculation unit may compute the device-specific power saving by multiplying the average power consumption by the cumulative duration.

Thus, the device-specific power saving can be calculated accurately.

Furthermore, this machine tool may further include a momentary power saving display instruction unit that displays, as a momentary power saving, a power obtained by adding together the average power consumptions of the electric devices determined by the signal determination unit to be in the power saving state, among the plurality of electric devices.

An operator of the machine tool can recognize the momentary power saving.

Furthermore, this machine tool may include a device-specific power saving display instruction unit that displays, for each of the electric devices, the device-specific power saving computed by the saving calculation unit.

The operator of the machine tool can recognize the device-specific power saving of each of the electric devices.

In addition, this machine tool may include a graph display instruction unit that displays a graph having the power saving calculated by the saving calculation unit and the elapsed time as axes.

The operator of the machine tool can recognize the relationship between the elapsed time and the power saving.

Here, the graph display instruction unit may display a time series graph showing the elapsed time from a desired timing and the power saving over the elapsed time.

A method for calculating a power saving of a machine tool according to the present invention, for solving the problems described above, is a method for calculating a power saving of a machine tool having a plurality of electric devices that consume power while energized, the method including: an energization signal detection step for detecting, for each of the electric devices, whether an energization signal is in an energization required state in which energization is required, or an energization non-required state in which energization is not required; a prohibition signal detection step for detecting, for each of the electric devices, whether an energization prohibition signal is in a prohibited state in which energization is prohibited, or a permitted state in which energization is permitted; a signal determination step for determining whether or not each of the electric devices is in a power saving state in which, in the energization signal detection step and the prohibition signal detection step, the energization signal and the energization prohibition signal for the electric device are respectively in the energization required state and the prohibited state; and a saving calculation step for determining a cumulative duration of the power saving state, computing a device-specific power saving for each of the electric devices on the basis of the cumulative duration, and calculating a power saving by adding together the device-specific power savings.

According to this method for calculating a power saving of a machine tool, the power saving can be calculated accurately. Moreover, since there is no need to operate the machine tool in a state where energization of the electric devices is not prohibited in order to calculate the power saving, the power saving can be calculated easily. Furthermore, the power saving can be calculated easily even in a case where the machine tool is operated after changing a part of an existing machining program or a case where the machine tool is operated by a new machining program.

According to the present invention, it is possible to provide a machine tool and a method for calculating a power saving of a machine tool, with which the power saving can be calculated accurately and easily.

### BRIEF DESCRIPTION OF THE DRAWINGS

FIG. 1 is a view showing a hardware configuration of a machine tool according to an embodiment;
FIG. 2 is a view showing a main functional configuration of an NC apparatus shown in FIG. 1;
FIG. 3 is a ladder diagram showing an operation for energizing a coolant pump according to this embodiment, among operations of a PLC shown in FIG. 2;
FIG. 4 is a ladder diagram showing an operation for energizing a spindle motor according to this embodiment, among the operations of the PLC shown in FIG. 2;
FIG. 5 is a ladder diagram showing an operation for energizing a rotary tool motor according to this embodiment, among the operations of the PLC shown in FIG. 2;
FIG. 6 is a flowchart showing an operation of a signal determination unit shown in FIG. 2;
FIG. 7 is a flowchart showing an operation of a saving calculation unit shown in FIG. 2; and
FIG. 8 is a view showing a display screen of a power saving and so on, which is displayed on a display part in response to an instruction from a display instruction unit shown in FIG. 2.

### DESCRIPTION OF THE PREFERRED EMBODIMENTS

An embodiment of the present invention will be described below with reference to the figures. In this embodiment, an example in which the present invention is applied to an NC lathe will be described.

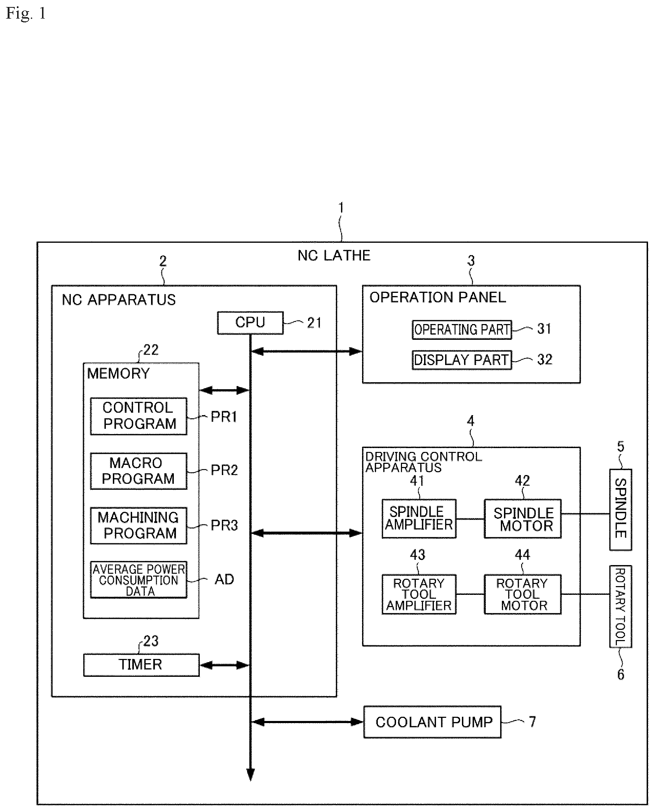

FIG. 1 is a view showing a hardware configuration of an NC lathe 1 according to this embodiment.

As shown in FIG. 1, the NC lathe 1 of this embodiment includes an NC apparatus 2, an operation panel 3, a driving control apparatus 4, a spindle 5, a rotary tool 6, and a coolant pump 7. The NC apparatus 2 includes a CPU 21, a memory 22, and a timer 23. The memory 22 includes a nonvolatile memory and a volatile memory. The CPU 21 temporarily stores a program and data stored in the nonvolatile memory, as well as data obtained during a calculation process and so on, in the volatile memory, and executes processing using the volatile memory as a working area.

The memory 22 stores a control program PR1, a macro program PR2, a machining program PR3, and average power consumption data AD. The control program PR1 is a program that serves as a basis for executing NC control on servo motors and control by a PLC on various electric devices. Further, the control program PR1 includes a program for realizing a function for displaying images on a display part 32 and a function for calculating a power saving. These functions will be described in detail below.

The macro program PR2 is a program in which a predetermined operation is described in advance by the manufacturer of the NC lathe 1. The memory 22 stores a plurality of macro programs PR2. Furthermore, an operator of the NC lathe 1 can create macro programs PR2 and store the created programs in the memory 22.

The machining program PR3 is also known as an NC program, and is mainly created by the operator of the NC lathe 1. The machining program PR3 is a program having a code system including a G code representing movement commands for a headstock, a tool post, and so on, a T code representing a call-up command for a tool to be used, an M code representing an auxiliary function command, and so on. The NC apparatus 2 controls operations of the tool post and a spindle in accordance with the machining program PR3, whereby a workpiece serving as a machining subject is machined to a desired shape, and the machined workpiece is cut off. The cut-off machined workpiece forms a product manufactured by the NC lathe 1. The manufactured product is discharged to a predetermined location by a product discharge operation. The machining, cutting off, and discharge operations form one cycle, and by executing the cycle a plurality of times, products are manufactured in the same number as the number of cycles. The NC apparatus 2 reads the machining program PR3 line by line, interprets the commands therein, and executes the commands described in the machining program PR3 in sequence while referring to data required to execute the commands. When execution of a macro program PR2 is specified in a read block, the CPU 21 executes the specified macro program PR2.

The average power consumption data AD are data indicating the average power consumption per unit time of a coolant pump 7, a spindle motor 42, and a rotary tool motor 44 while energized. The spindle motor 42, the rotary tool motor 44, and the coolant pump 7 correspond to examples of electric devices. Note that the NC lathe 1 includes many other electric devices, such as servo motors for respectively moving a front headstock, a front tool post, a back headstock, and a back tool post, as well as a cooling fan, a product conveyor, a door lock switch, a spindle cooling apparatus, and lighting equipment, but in FIG. 1, these devices have been omitted for simplicity. Hereinafter, the spindle motor 42, the rotary tool motor 44, and the coolant pump 7 will be referred to as target electric devices, and the other electric devices will be referred to as other electric devices. With regard to the coolant pump 7, a power consumption constituted by the power consumed during a coolant discharge operation is stored in the memory 22 as the average power consumption data AD. With regard to each of the spindle motor 42 and the rotary tool motor 44, meanwhile, a power consumption constituted by the power consumed when the motor is excited in order to maintain a motor output shaft in a non-rotating state is stored in the memory 22 as the average power consumption data AD. As regards the value of the average power consumption in the average power consumption data AD, with respect to the coolant pump 7, a catalog value of the pump is stored in the memory 22. Note, however, that the coolant pump 7 may be operated, the power consumption may be measured using a watt meter, and the measured value may be set as the average power consumption data AD of the coolant pump 7. As regards the spindle motor 42 and the rotary tool motor 44, the power consumption in a non-rotating, excited state is measured using a watt meter (not shown), and the measured value is stored in the memory 22 prior to factory shipment as the average power consumption data AD. Likewise with regard to the spindle motor 42 and the rotary tool motor 44, however, if the power consumption in a non-rotating, excited state exists as a catalog value of the motor, the catalog value may be used as the average power consumption data AD. Note that the average power consumption data AD stored in the memory 22 can be modified as appropriate either before or after factory shipment.

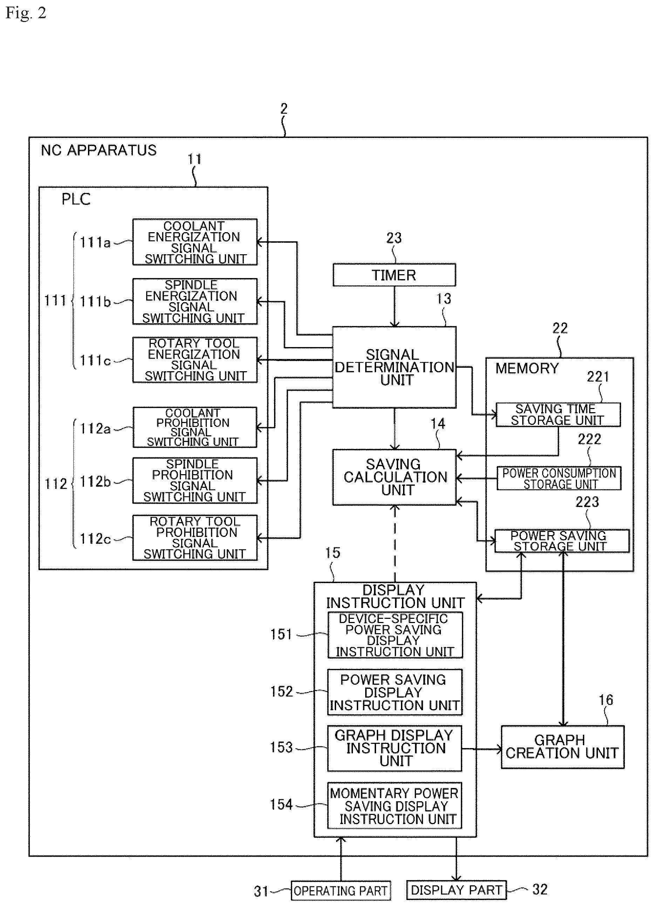

The timer 23 is used to measure the passage of time. For example, the timer 23 is used to measure the elapsed time after switching on a power supply of the NC lathe 1, and to operate a signal determination unit 13 (see FIG. 2) and a saving calculation unit 14 (see FIG. 2), to be described below, at predetermined time intervals.

The operation panel 3 includes an operating part 31 and the display part 32. The operating part 31 is constituted by a plurality of buttons, keys, and so on for receiving input operations performed by the operator of the NC lathe 1. Note that the operating part 31 may also be a touch panel that is integrated with the display part 32. The operator can store the machining program PR3 created using the operating part 31 or an external computer in the memory 22. The operator can also correct the machining program PR3 using the operating part 31 and store the corrected machining program PR3 in the memory 22. Furthermore, the operator can use the operating part 31 to switch between an ECO mode and a normal mode, to be described below, and to select a target electric device that is to serve as a power saving target.

The display part 32 is a display for displaying various information relating to the NC lathe 1, such as the macro programs PR2, the machining program PR3, various setting values, error content, and a power saving instructed by a display instruction unit 15 (see FIG. 2), to be described below.

The driving control apparatus 4 includes a spindle amplifier 41, the spindle motor 42, a rotary tool amplifier 43, and the rotary tool motor 44. The spindle motor 42 and the rotary tool motor 44 correspond to examples of a motor. Note that although omitted from the figures here for simplicity, a servo motor and a servo amplifier for moving each of the front headstock, the front tool post, the back headstock, and the back tool post are provided in the driving control apparatus 4 for each movement axis. The spindle amplifier 41 and the spindle motor 42 according to this embodiment are an amplifier and a motor for rotating a back spindle (the spindle 5). Note that the driving control apparatus 4 is also provided with an amplifier and a motor for rotating a front spindle, but these components have been omitted here. Furthermore, the rotary tool amplifier 43 and the rotary tool motor 44 are provided for each tool post to which the rotary tool 6 can be attached.

The spindle 5 is a part that is rotated by the spindle motor 42. The spindle 5 is provided on the back headstock. The spindle 5 corresponds to an example of a spindle. Note that the front headstock is provided with a front spindle, but the front spindle has been omitted here. The rotary tool 6 is a tool that is rotated by the rotary tool motor 44, and is disposed in a cutting chamber in which the workpiece is machined. Many NC lathes 1 are configured such that a plurality of rotary tools 6 can be attached to a single tool post. The plurality of rotary tools 6 attached to the single tool post are rotated by a single rotary tool motor 44. The coolant pump 7 is a pump used to circulate a coolant liquid. The coolant pump 7 discharges the coolant liquid into the cutting chamber by being energized.

FIG. 2 is a view showing a main functional configuration of the NC apparatus 2 shown in FIG. 1.

As shown in FIG. 2, the NC apparatus 2 includes, as functional configurations, a PLC 11, the signal determination unit 13, the saving calculation unit 14, the display instruction unit 15, and a graph creation unit 16. These functional configurations are mainly realized by the CPU 21 and the control program PR1 shown in FIG. 1. The PLC 11 includes an energization signal switching unit 111 and a prohibition signal switching unit 112. The energization signal switching unit 111 switches an energization signal set for each of the target electric devices provided in the NC lathe 1 (see FIG. 1) between an energization required state in which energization of the corresponding target electric device is required, and an energization non-required state in which energization is not required. Note that the PLC 11 also controls signals for switching energization and operations of the other electric devices provided in the NC lathe 1, but FIG. 2 only shows components relating to this embodiment. In the normal mode, energization and energization stoppage of the target electric device are controlled only by the energization signal switched by the energization signal switching unit 111. More specifically, in the energization required state, the target electric device is energized, and in the energization non-required state, energization of the target electric device is stopped. The PLC 11 of this embodiment switches between the energization required state and the energization non-required state by switching a signal voltage between an H level and an L level. Note, however, that another method may be used to switch between the energization required state and the energization non-required state. The energization signal switching unit 111 of this embodiment includes a coolant energization signal switching unit 111a, a spindle energization signal switching unit 111b, and a rotary tool energization signal switching unit 111c.

The coolant energization signal switching unit 111a switches an energization signal for the coolant pump 7 (see FIG. 1) between a coolant energization required state, which is the energization required state for the coolant pump 7, and a coolant energization non-required state, which is the energization non-required state for the coolant pump 7. The spindle energization signal switching unit 111b switches an energization signal for the spindle motor 42 (see FIG. 1) between a spindle energization required state, which is the energization required state for the spindle motor 42, and a spindle energization non-required state, which is the energization non-required state for the spindle motor 42. The rotary tool energization signal switching unit 111c switches an energization signal for the rotary tool motor 44 (see FIG. 1) between a rotary tool energization required state, which is the energization required state for the rotary tool motor 44, and a rotary tool energization non-required state, which is the energization non-required state for the rotary tool motor 44. The energization signals switched by the coolant energization signal switching unit 111a, the spindle energization signal switching unit 111b, and the rotary tool energization signal switching unit 111c are respectively monitored by the signal determination unit 13 either at predetermined time intervals of 8 msec or the like, or constantly. Note that instead of having the signal determination unit 13 monitor the states of the energization signals directly, state information about the energization signals may be stored in a predetermined area of the memory 22, and the signal determination unit 13 may be configured to obtain the state information about the energization signals stored in this predetermined area. In other words, the signal determination unit 13 may monitor the states of the energization signals indirectly.

The prohibition signal switching unit 112 switches an energization prohibition signal set for each of the target electric devices provided in the NC lathe 1 (see FIG. 1) between a prohibited state in which energization of the corresponding target electric device is prohibited, and a permitted state in which energization is permitted. The PLC 11 of this embodiment switches between the prohibited state and the permitted state by switching the signal voltage between an H level and an L level. Note, however, that another method may be used to switch between the prohibited state and the permitted state. The prohibition signal switching unit 112 of this embodiment includes a coolant prohibition signal switching unit 112a, a spindle prohibition signal switching unit 112b, and a rotary tool prohibition signal switching unit 112c.

The coolant prohibition signal switching unit 112a switches an energization prohibition signal for the coolant pump 7 (see FIG. 1) between a coolant prohibited state, which is the prohibited state for the coolant pump 7, and a coolant permitted state, which is the permitted state for the coolant pump 7. The spindle prohibition signal switching unit 112b switches an energization prohibition signal for the spindle motor 42 (see FIG. 1) between a spindle prohibited state, which is the prohibited state for the spindle motor 42, and a spindle permitted state, which is the permitted state for the spindle motor 42. The rotary tool prohibition signal switching unit 112c switches an energization prohibition signal for the rotary tool motor 44 (see FIG. 1) between a rotary tool prohibited state, which is the prohibited state for the rotary tool motor 44, and a rotary tool permitted state, which is the permitted state for the rotary tool motor 44. The energization prohibition signals switched by the coolant prohibition signal switching unit 112a, the spindle prohibition signal switching unit 112b, and the rotary tool prohibition signal switching unit 112c are respectively monitored by the signal determination unit 13 either at predetermined time intervals of 8 msec or the like, or constantly. Note that instead of having the signal determination unit 13 monitor the states of the energization prohibition signals directly, state information about the energization prohibition signals may be stored in a predetermined area of the memory 22, and the signal determination unit 13 may be configured to obtain the state information about the energization prohibition signals stored in this predetermined area. In other words, the signal determination unit 13 may monitor the states of the energization prohibition signals indirectly.

The signal determination unit 13 receives the signals switched by the energization signal switching unit 111 and the prohibition signal switching unit 112, and determines, for each of the target electric devices, whether or not the energization signal for the target electric device is in the energization required state and the energization prohibition signal is in the prohibited state. Hereinafter, a state in which the energization signal is in the energization required state and the energization prohibition signal is in the prohibited state may be referred to as a power saving state. The signal determination unit 13 constantly acquires information indicating the elapsed time after switching on the power supply of the NC lathe 1 (see FIG. 1) from the timer 23. The signal determination unit 13 determines whether or not the target electric device is in the power saving state every 8 msec, for example, after switching on the power supply of the NC lathe 1. The timing of this determination may be a timing other than 8 msec, and monitoring may be performed constantly by starting the next determination operation as soon as the previous determination is complete. When the power saving state is established, the signal determination unit 13 stores information indicating that the power saving state is established in a saving time storage unit 221 provided in the memory 22 following each determination. Here, the signal determination unit 13 compares the previous determination result with the current determination result, and stores changed state information in the saving time storage unit 221 only when there has been a change. Thus, the area of the memory 22 used to store the determination results can be reduced. Furthermore, the signal determination unit 13 may store the determination result in the saving time storage unit 221 at a different time interval to the time interval of the determination, for example every minute or the like. Note that this time interval is preferably aligned with a time interval at which the display instruction unit 15 updates the display on the display part 32. Thus, likewise in this case, the area of the memory 22 used to store the determination results can be reduced. Information indicating the elapsed time after switching on the power supply of the NC lathe 1 is attached to the information stored in the saving time storage unit 221. Note that even when the power saving state is not established, the signal determination unit 13 may store information indicating that the power saving state is not established together with information indicating the elapsed time in the saving time storage unit 221 provided in the memory 22. Furthermore, after determining that the power saving state is established, the signal determination unit 13 transmits information indicating that the power saving state is established to the saving calculation unit 14 after each determination.

The saving calculation unit 14 executes the following processing at intervals of 8 msec, i.e., identical intervals to the signal determination unit 13. First, the saving calculation unit 14 determines a cumulative duration of the time during which each of the target electric devices has been in the power saving state by accumulating the duration of the power saving state, which is stored in the saving time storage unit 221, for each target electric device. The saving calculation unit 14 then computes a device-specific power saving by multiplying the cumulative duration by the average power consumption of each target electric device. Here, a value obtained by referring to the average power consumption data AD (see FIG. 1) is used as the average power consumption of each target electric device. Next, the saving calculation unit 14 calculates a power saving by adding together the device-specific power savings computed for all of the target electric devices. Furthermore, by adding together the average power consumptions of the target electric devices in the power saving state, received from the signal determination unit 13 over the past 8 msec, the saving calculation unit 14 calculates a momentary power saving, which is the amount of power being saved at that point in time. The saving calculation unit 14 then stores the device-specific power savings, the power saving, and the momentary power saving thus obtained in a power saving storage unit 223. As indicated by a dotted-line arrow in FIG. 2, the saving calculation unit 14 may compute, calculate, or create only an element that is required by the display instruction unit 15, among the device-specific power savings, the power saving, the momentary power saving, and a time series graph, and store the element in the power saving storage unit 223.

When a request is issued by a graph display instruction unit 153, the graph creation unit 16 uses the data stored in the power saving storage unit 223 to create a time series graph that represents the transition of the power saving relative to the elapsed time after switching on the power supply of the NC lathe 1 using the elapsed time and the power saving as axes. The graph creation unit 16 then stores the created time series graph in the power saving storage unit 223. Note that the graph creation unit 16 may transmit the created time series graph to the graph display instruction unit 153.

The display instruction unit 15 causes the display part 32 to display information requested by an input operation performed on the operating part 31 by the operator of the NC lathe 1. The display instruction unit 15 includes a device-specific power saving display instruction unit 151, a power saving display instruction unit 152, the graph display instruction unit 153, and a momentary power saving display instruction unit 154. The device-specific power saving display instruction unit 151 calls up the device-specific power savings stored in the power saving storage unit 223 by the saving calculation unit 14, and displays the device-specific power savings for the respective target electric devices on the display part 32. The power saving display instruction unit 152 calls up the power saving stored in the power saving storage unit 223 by the saving calculation unit 14, and displays the power saving on the display part 32. The graph display instruction unit 153 calls up the time series graph stored in the power saving storage unit 223 by the graph creation unit 16, and displays the time series graph on the display part 32. Here, the graph display instruction unit 153 also has a function for cutting out an elapsed time of a period specified by the operator and the power saving over the specified elapsed time from the time series graph created by the graph creation unit 16, and displaying the result on the display part 32. The momentary power saving display instruction unit 154 calls up the momentary power saving stored in the power saving storage unit 223 by the saving calculation unit 14, and displays the momentary power saving on the display part 32.

The memory 22 includes the saving time storage unit 221, a power consumption storage unit 222, and the power saving storage unit 223. As described above, information indicating, at 8 msec intervals, whether or not the target electric device has been in the power saving state since the power supply of the NC lathe 1 (see FIG. 1) was switched on is associated with information indicating the time that has elapsed since the power supply of the NC lathe 1 was switched on and stored thus in the saving time storage unit 221 for each target electric device. The power consumption storage unit 222 stores the average power consumption data AD of each of the target electric devices. The power saving storage unit 223 stores the device-specific power savings, the power saving, and the momentary power saving, computed or calculated by the saving calculation unit 14, as well as information about the time series graph created by the graph creation unit 16.

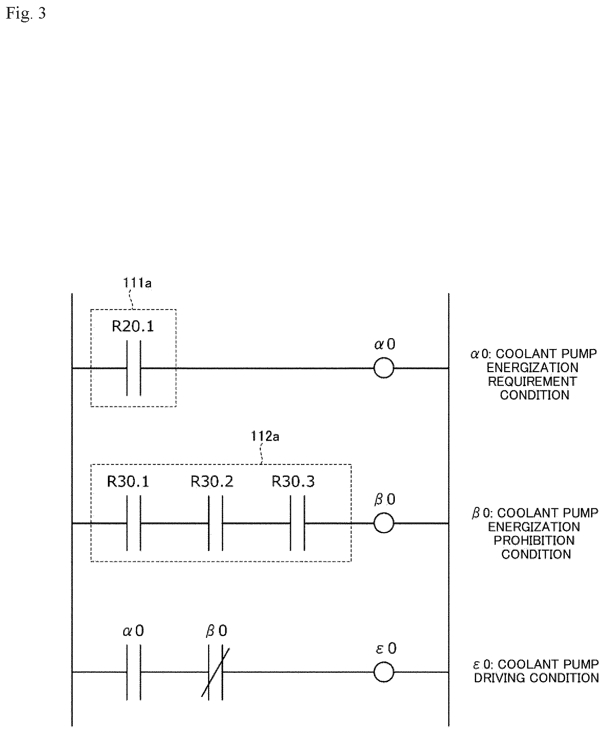

FIG. 3 is a ladder diagram showing an operation for energizing the coolant pump 7 according to this embodiment, among the operations of the PLC 11 shown in FIG. 2.

A contact R20.1, a contact R30.1, a contact R30.2, a contact R30.3, and a contact α0 shown on the ladder diagram in FIG. 3 are so-called A contacts, while a contact β0 is a so-called B contact. When the contact R20.1 is ON, a signal α0 switches ON (H level), and when the contact R20.1 is OFF, the signal α0 switches OFF (L level). The signal α0 corresponds to an example of the energization signal for the coolant pump 7. Further, the contact R20.1 at which the signal α0 is switched ON/OFF corresponds to the coolant energization signal switching unit 111a. A state in which the signal α0 is ON is the coolant energization required state, and a state in which the signal α0 is OFF is the coolant energization non-required state. During sequential execution of the commands described in the machining program PR3 (see FIG. 1), the contact R20.1 switches ON when the current command is a command for driving the coolant pump 7 and switches OFF when the command is a command for stopping driving of the coolant pump 7.

Further, when the contact R30.1, the contact R30.2, and the contact R30.3 are all ON, a signal β0 switches ON, and when any one of the contact R30.1, the contact R30.2, and the contact R30.3 is OFF, the signal β0 switches OFF. The signal β0 corresponds to an example of the energization prohibition signal for the coolant pump 7. Furthermore, the contact R30.1, the contact R30.2, and the contact R30.3 at which the signal β0 is switched ON/OFF correspond to the coolant prohibition signal switching unit 112a. A state in which the signal β0 is ON is the coolant prohibited state, and a state in which the signal β0 is OFF is the coolant permitted state. The contact R30.1 switches ON when the ECO mode is selected and switches OFF when the normal mode is selected. The contact R30.2 switches ON when the coolant pump 7 is included in the power saving targets and switches OFF when the coolant pump 7 is not included. Whether or not to include the coolant pump 7 in the power saving targets can be changed as desired by the operator of the NC lathe 1 (see FIG. 1) using the operating part 31 (see FIG. 1). The contact R30.3 is a contact which, during sequential execution of the commands described in the machining program PR3 (see FIG. 1), switches ON when the current command is a command specifying execution of the macro program PR2 for performing the product discharge operation, and switches OFF when execution of the macro program PR2 for performing the product discharge operation is complete. The period from the start to the end of the product discharge operation corresponds to an example of a predetermined period, and whether or not the predetermined period is underway corresponds to an example of a predetermined condition on which the prohibition signal switching unit 112 determines whether or not to switch to the prohibited state in which energization is prohibited. Furthermore, the coolant pump 7 is associated with the macro program PR2 for performing the product discharge operation or a command for calling up this macro program PR2. Note that when the product discharge operation is not performed using the macro program PR2, the PLC 11 determines the start and end of the product discharge operation in the following manner, for example. The back spindle includes a chuck that can be opened and closed and that grips the workpiece when closed. The PLC 11 determines that the product discharge operation has started and switches the contact R30.3 ON when a command for moving the back spindle to a first position for discharging the product has been executed or when a command for opening the chuck gripping the machined workpiece has been executed. Further, the PLC 11 determines that the product discharge operation is complete and switches the contact R30.3 OFF when a command for closing the chuck gripping the workpiece after moving the back spindle to a second position for gripping the product has been executed.

As described above, the contact α0 is an A contact and therefore switches ON when the signal α0 is ON (H level) and switches OFF when the signal α0 is OFF (L level). The contact β0 is a B contact and therefore switches ON when the signal β0 is OFF (L level) and switches OFF when the signal β0 is ON (H level). The PLC 11 switches the contact α0 ON when the signal α0 is ON such that the coolant energization required state is established. Meanwhile, the PLC 11 switches the contact α0 OFF when the signal α0 is OFF such that the coolant energization non-required state is established. The process by which the PLC 11 detects the signal α0 corresponds to an example of an energization signal detection step. Further, the PLC 11 switches the contact β0 ON when the signal β0 is OFF such that the coolant permitted state is established. Meanwhile, the PLC 11 switches the contact β0 OFF when the signal β0 is ON such that the coolant prohibited state is established. The process by which the PLC 11 detects the signal β0 corresponds to an example of a prohibition signal detection step. When the contact α0 is ON and the contact β0 is ON, a signal ε0 switches ON, thereby energizing the coolant pump 7 such that the coolant pump 7 is driven. When the contact α0 is OFF or the contact β0 is OFF, on the other hand, the signal ε0 switches OFF such that the coolant pump 7 is not energized, and as a result, the coolant pump 7 stops. As described above, a state in which the signal α0 is in the coolant energization required state and the signal β0 is in the coolant prohibited state corresponds to the power saving state of the coolant pump 7.

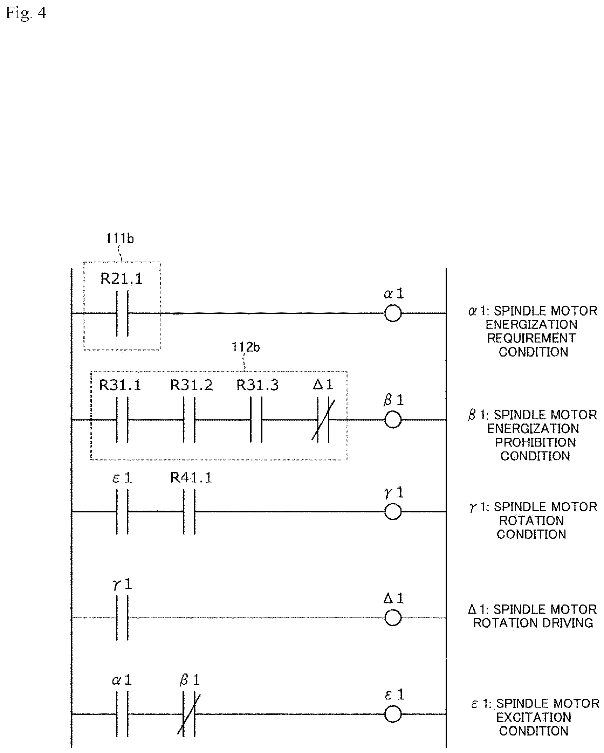

FIG. 4 is a ladder diagram showing an operation for energizing the spindle motor 42 according to this embodiment, among the operations of the PLC 11 shown in FIG. 2.

A contact R21.1, a contact R31.1, a contact R31.2, a contact R31.3, a contact ε1, a contact R41.1, a contact γ1, and a contact α1 shown on the ladder diagram in FIG. 4 are so-called A contacts, while a contact Δ1 and a contact β1 are so-called B contacts. When the contact R21.1 is ON, a signal α1 switches ON, and when the contact R21.1 is OFF, the signal α1 switches OFF. The signal α1 corresponds to an example of the energization signal for the spindle motor 42. Further, the contact R21.1 at which the signal α1 is switched ON/OFF corresponds to the spindle energization signal switching unit 111b. A state in which the signal α1 is ON is the spindle energization required state, and a state in which the signal α1 is OFF is the spindle energization non-required state. During sequential execution of the commands described in the machining program PR3 (see FIG. 1), the contact R21.1 switches ON when the current command is a command for exciting the spindle motor 42 and switches OFF when the command is a command for stopping excitation of the spindle motor 42.

Further, when the contact R31.1, the contact R31.2, the contact R31.3, and the contact Δ1 are all ON, a signal β1 switches ON, and when any one of the contact R31.1, the contact R31.2, the contact R31.3, and the contact Δ1 is OFF, the signal β1 switches OFF. The signal β1 corresponds to an example of the energization prohibition signal for the spindle motor 42. Furthermore, the contact R31.1, the contact R31.2, the contact R31.3, and the contact Δ1 at which the signal β1 is switched ON/OFF correspond to the spindle prohibition signal switching unit 112b. A state in which the signal β1 is ON is the spindle prohibited state, and a state in which the signal β1α is OFF is the spindle permitted state. The contact R31.1 switches ON when the ECO mode is selected and switches OFF when the normal mode is selected. The contact R31.2 switches ON when the spindle motor 42 is included in the power saving targets and switches OFF when the spindle motor 42 is not included. Whether or not to include the spindle motor 42 in the power saving targets can be changed as desired by the operator of the NC lathe 1 (see FIG. 1) using the operating part 31 (see FIG. 1). The contact R31.3 is a contact which, similarly to the contact R30.3, during sequential execution of the commands described in the machining program PR3 (see FIG. 1), switches ON when the current command is a command specifying execution of the macro program PR2 for performing the product discharge operation, and switches OFF when execution of the macro program PR2 for performing the product discharge operation is complete. In other words, the spindle motor 42 is associated with the macro program PR2 for performing the product discharge operation or a command for calling up this macro program PR2. As described above, here, the spindle motor 42 is a motor for rotating the back spindle (the spindle 5 in FIG. 1) mounted on the back headstock. When the product discharge operation is not performed by the macro program PR2, the PLC 11 determines the start and end of the product discharge operation using a similar determination method to the content described in relation to the contact R30.3.

When the signal α1 is ON such that the spindle energization required state is established, the PLC 11 switches the contact α1 ON. Meanwhile, when the signal α1 is OFF such that the spindle energization non-required state is established, the PLC 11 switches the contact α1 OFF. The process by which the PLC 11 detects the signal α1 corresponds to an example of the energization signal detection step. Further, the PLC 11 switches the contact β1 ON when the signal β1 is OFF such that the spindle permitted state is established. Meanwhile, the PLC 11 switches the contact β1 OFF when the signal β1 is ON such that the spindle prohibited state is established. The process by which the PLC 11 detects the signal β1 corresponds to an example of the prohibition signal detection step. When the contact α1 is ON and the contact β1 is ON, a signal ε1 switches ON, thereby energizing the spindle motor 42 such that the spindle motor 42 is excited. When excited, the spindle motor 42 is in either a non-rotating state and a state in which an output shaft thereof does not rotate even when external force is exerted thereon in a rotation direction (a signal Δ1 to be described below is OFF), or a state in which the output shaft is rotating (the signal Δ1 to be described below is ON). When the contact α1 is OFF or the contact β1 is OFF, on the other hand, the signal ε1 switches OFF such that the spindle motor 42 is not energized, and as a result, the spindle motor 42 is not excited. When not excited, the spindle motor 42 is in a non-rotating state and a state in which the output shaft rotates when external force is exerted thereon in the rotation direction. As described above, a state in which the signal α1 is in the spindle energization required state and the signal β1 is in the spindle prohibited state corresponds to the power saving state of the spindle motor 42.

The contact Δ1 mentioned above switches OFF when the signal Δ1 is ON and switches ON when the signal Δ1 is OFF. When the signal Δ1 is ON, the output shaft of the spindle motor 42 rotates, and when the signal Δ1 is OFF, the output shaft of the spindle motor 42 stops. In other words, the signal Δ1 corresponds to a rotation signal of the spindle motor 42. The signal Δ1 switches ON when the contact γ1 is ON and switches OFF when the contact γ1 is OFF. Further, the contact γ1 switches ON when a signal γ1 is ON and switches OFF when the signal γ1 is OFF. The signal γ1 switches ON when the contact ε1 is ON and the contact R41.1 is ON, and switches OFF when either one of the contact ε1 and the contact R41.1 is OFF. The contact ε1 switches ON when the signal ε1 is ON and switches OFF when the signal ε1 is OFF. The contact R41.1 is a contact which, during sequential execution of the commands described in the machining program PR3 (see FIG. 1), switches ON when the current command is a command for rotating the spindle motor 42, and switches OFF when the command is a command for stopping rotation of the spindle motor 42.

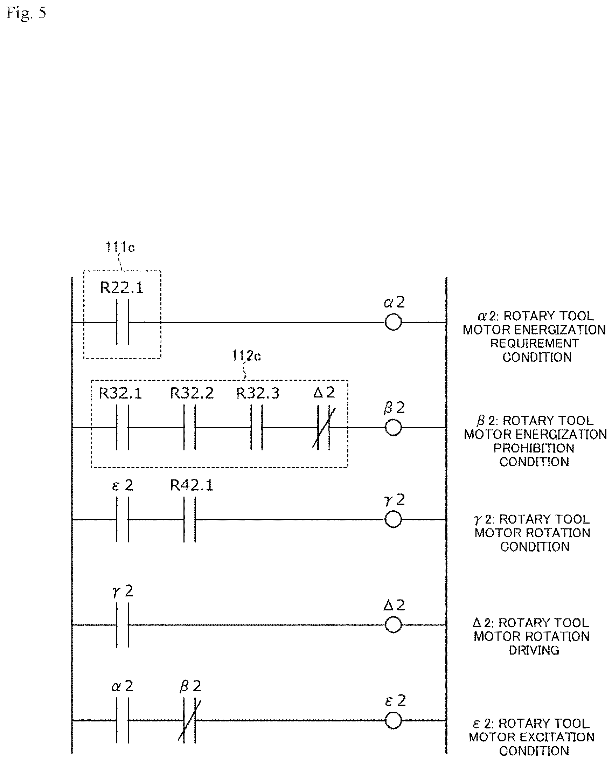

FIG. 5 is a ladder diagram showing an operation for energizing the rotary tool motor 44 according to this embodiment, among the operations of the PLC 11 shown in FIG. 2.

A contact R22.1, a contact R32.1, a contact R32.2, a contact R32.3, a contact ε2, a contact R42.1, a contact γ2, and a contact α2 shown on the ladder diagram in FIG. 5 are so-called A contacts, while a contact Δ2 and a contact β2 are so-called B contacts. When the contact R22.1 is ON, a signal α2 switches ON, and when the contact R22.1 is OFF, the signal α2 switches OFF. The signal α2 corresponds to an example of the energization signal for the rotary tool motor 44. Further, the contact R22.1 at which the signal α2 is switched ON/OFF corresponds to the rotary tool energization signal switching unit 111c. A state in which the signal α2 is ON is the rotary tool energization required state, and a state in which the signal α2 is OFF is the rotary tool energization non-required state. During sequential execution of the commands described in the machining program PR3 (see FIG. 1), the contact R22.1 switches ON when the current command is a command for exciting the rotary tool motor 44 and switches OFF when the command is a command for stopping excitation of the rotary tool motor 44.

Further, when the contact R32.1, the contact R32.2, the contact R32.3, and the contact Δ2 are all ON, a signal β2 switches ON, and when any one of the contact R32.1, the contact R32.2, the contact R32.3, and the contact Δ2 is OFF, the signal β2 switches OFF. The signal β2 corresponds to an example of the energization prohibition signal for the rotary tool motor 44. Furthermore, the contact R32.1, the contact R32.2, the contact R32.3, and the contact Δ2 at which the signal β2 is switched ON/OFF correspond to the rotary tool prohibition signal switching unit 112c. A state in which the signal β2 is ON is the rotary tool prohibited state, and a state in which the signal β2α is OFF is the rotary tool permitted state. The contact R32.1 switches ON when the ECO mode is selected and switches OFF when the normal mode is selected. The contact R32.2 switches ON when the rotary tool motor 44 is included in the power saving targets and switches OFF when the rotary tool motor 44 is not included. Whether or not to include the rotary tool motor 44 in the power saving targets can be changed as desired by the operator of the NC lathe 1 (see FIG. 1) using the operating part 31 (see FIG. 1). The contact R32.3 is a contact which, during sequential execution of the commands described in the machining program PR3 (see FIG. 1), switches ON when the current command is a command specifying execution of the macro program PR2 for selecting a tool other than the rotary tool, and switches OFF when execution of the macro program PR2 for selecting a tool other than the rotary tool is complete. In other words, the rotary tool motor 44 is associated with the macro program PR2 for selecting a tool other than the rotary tool or a command for calling up this macro program PR2. Note that here, execution of the macro program PR2 for selecting a tool other than the rotary tool is complete when execution of the macro program PR2 for selecting the rotary tool is started. In other words, a period during which a state in which a tool other than the rotary tool has been selected by executing the macro program PR2 for selecting a tool other than the rotary tool is continuously established corresponds to an example of the predetermined period, and whether or not the predetermined period is underway corresponds to an example of the predetermined condition on which the prohibition signal switching unit 112 determines whether or not to switch to the prohibited state in which energization is prohibited.

When the signal α2 is ON such that the rotary tool energization required state is established, the PLC 11 switches the contact α2 ON. Meanwhile, when the signal α2 is OFF such that the rotary tool energization non-required state is established, the PLC 11 switches the contact α2 OFF. The process by which the PLC 11 detects the signal α2 corresponds to an example of the energization signal detection step. Further, the PLC 11 switches the contact β2 ON when the signal β2 is OFF such that the rotary tool permitted state is established. Meanwhile, the PLC 11 switches the contact β2 OFF when the signal β2 is ON such that the rotary tool prohibited state is established. The process by which the PLC 11 detects the signal β2 corresponds to an example of the prohibition signal detection step. When the contact α2 is ON and the contact β2 is ON, a signal ε2 switches ON, thereby energizing the rotary tool motor 44 such that the rotary tool motor 44 is excited. When excited, the rotary tool motor 44 is in either a non-rotating state and a state in which an output shaft thereof does not rotate even when external force is exerted thereon in a rotation direction (a signal Δ2 to be described below is OFF), or a state in which the output shaft is rotating (the signal Δ2 to be described below is ON). When the contact α2 is OFF or the contact β2 is OFF, on the other hand, the signal ε2 switches OFF such that the rotary tool motor 44 is not energized, and as a result, the rotary tool motor 44 is not excited. When not excited, the rotary tool motor 44 is in a non-rotating state and a state in which the output shaft rotates when external force is exerted thereon in the rotation direction. As described above, a state in which the signal α2 is in the rotary tool energization required state and the signal β2 is in the rotary tool prohibited state corresponds to the power saving state of the rotary tool motor 44.

The contact Δ2 mentioned above switches OFF when the signal Δ2 is ON and switches ON when the signal Δ2 is OFF. When the signal Δ2 is ON, the output shaft of the rotary tool motor 44 rotates, and when the signal Δ2 is OFF, the output shaft of the rotary tool motor 44 stops. In other words, the signal Δ2 corresponds to a rotation signal of the rotary tool motor 44. The signal Δ2 switches ON when the contact γ2 is ON and switches OFF when the contact γ2 is OFF. Further, the contact γ2 switches ON when a signal y2 is ON and switches OFF when the signal γ2 is OFF. The signal γ2 switches ON when the contact ε2 is ON and the contact R42.1 is ON, and switches OFF when either one of the contact ε2 and the contact R42.1 is OFF. The contact ε2 switches ON when the signal ε2 is ON and switches OFF when the signal ε2 is OFF. The contact R42.1 is a contact which, during sequential execution of the commands described in the machining program PR3 (see FIG. 1), switches ON when the current command is a command for rotating the rotary tool motor 44, and switches OFF when the command is a command for stopping rotation of the rotary tool motor 44.

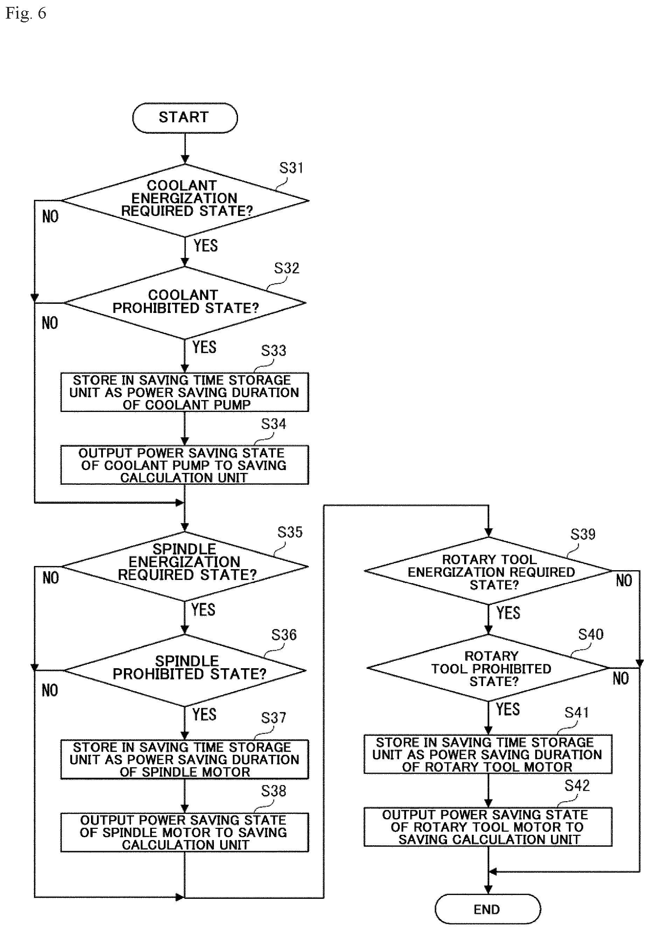

FIG. 6 is a flowchart showing an operation of the signal determination unit 13 shown in FIG. 2. The operation shown in FIG. 6 is executed every 8 msec, for example, after switching on the power supply of the NC lathe 1 (see FIG. 1).

As shown in FIG. 6, the signal determination unit 13 determines whether or not the signal α0 is in the coolant energization required state (step S31). When the coolant energization required state is established (YES in step S31), the signal determination unit 13 determines whether or not the signal β0 is in the coolant prohibited state (step S32). When the coolant prohibited state is established (YES in step S32), the signal determination unit 13 stores information indicating that the coolant pump 7 is in the power saving state together with information indicating the elapsed time up to execution of the current determination after switching on the power supply of the NC lathe 1 in the saving time storage unit 221 (step S33). Note that a case in which YES is obtained in both step S31 and step S32 corresponds to the power saving state of the coolant pump 7, i.e., a state in which the coolant pump 7 is stopped even though the command to drive the coolant pump 7 remains in effect. The steps S31 and S32 correspond to an example of a signal determination step. Next, the signal determination unit 13 outputs information indicating that the coolant pump 7 is in the power saving state to the saving calculation unit 14 (step S34). When the signal α0 is not in the coolant energization required state (NO in step S31), when the signal β0 is not in the coolant prohibited state (NO in step S32), or when the execution of step S34 is complete, the processing advances to step S35. Here, when the signal α0 is not in the coolant energization required state (NO in step S31) or when the signal β0 is not in the coolant prohibited state (NO in step S32), the signal determination unit 13 may store information indicating that the coolant pump 7 is not in the power saving state in the saving time storage unit 221 together with information indicating the elapsed time after switching on the power supply of the NC lathe 1, or may output this information to the saving calculation unit 14.

In step S35, the signal determination unit 13 determines whether or not the signal α1 is in the spindle energization required state. When the spindle energization required state is established (YES in step S35), the signal determination unit 13 determines whether or not the signal β1 is in the spindle prohibited state (step S36). When the spindle prohibited state is established (YES in step S36), the signal determination unit 13 stores information indicating that the spindle motor 42 is in the power saving state together with information indicating the elapsed time up to execution of the current determination after switching on the power supply of the NC lathe 1 in the saving time storage unit 221 (step S37). Note that a case in which YES is obtained in both step S35 and step S36 corresponds to the power saving state of the spindle motor 42, i.e., a state in which the spindle motor 42 is not excited even though the command to excite the spindle motor 42 remains in effect. The steps S35 and S36 correspond to an example of the signal determination step. Next, the signal determination unit 13 outputs information indicating that the spindle motor 42 is in the power saving state to the saving calculation unit 14 (step S38). When the signal α1 is not in the spindle energization required state (NO in step S35), when the signal β1 is not in the spindle prohibited state (NO in step S36), or when the execution of step S38 is complete, the processing advances to step S39. Here, when the signal α1 is not in the spindle energization required state (NO in step S35) or when the signal β1 is not in the spindle prohibited state (NO in step S36), the signal determination unit 13 may store information indicating that the spindle motor 42 is not in the power saving state in the saving time storage unit 221 together with information indicating the elapsed time after switching on the power supply of the NC lathe 1, or may output this information to the saving calculation unit 14.

In step S39, the signal determination unit 13 determines whether or not the signal α2 is in the rotary tool energization required state. When the rotary tool energization required state is established (YES in step S39), the signal determination unit 13 determines whether or not the signal β2 is in the rotary tool prohibited state (step S40). When the rotary tool prohibited state is established (YES in step S40), the signal determination unit 13 stores information indicating that the rotary tool motor 44 is in the power saving state together with information indicating the elapsed time up to execution of the current determination after switching on the power supply of the NC lathe 1 in the saving time storage unit 221 (step S41). Note that a case in which YES is obtained in both step S39 and step S40 corresponds to the power saving state of the rotary tool motor 44, i.e., a state in which the rotary tool motor 44 is not excited even though the command to excite the rotary tool motor 44 remains in effect. The steps S39 and S40 correspond to an example of the signal determination step. Next, the signal determination unit 13 outputs information indicating that the rotary tool motor 44 is in the power saving state to the saving calculation unit 14 (step S42). When the signal α2 is not in the rotary tool energization required state (NO in step S39), when the signal β2 is not in the rotary tool prohibited state (NO in step S40), or when the execution of step S42 is complete, the signal determination unit 13 terminates the processing. Here, when the signal α2 is not in the rotary tool energization required state (NO in step S39) or when the signal β2 is not in the rotary tool prohibited state (NO in step S40), the signal determination unit 13 may store information indicating that the rotary tool motor 44 is not in the power saving state in the saving time storage unit 221 together with information indicating the elapsed time after switching on the power supply of the NC lathe 1, or may output this information to the saving calculation unit 14.

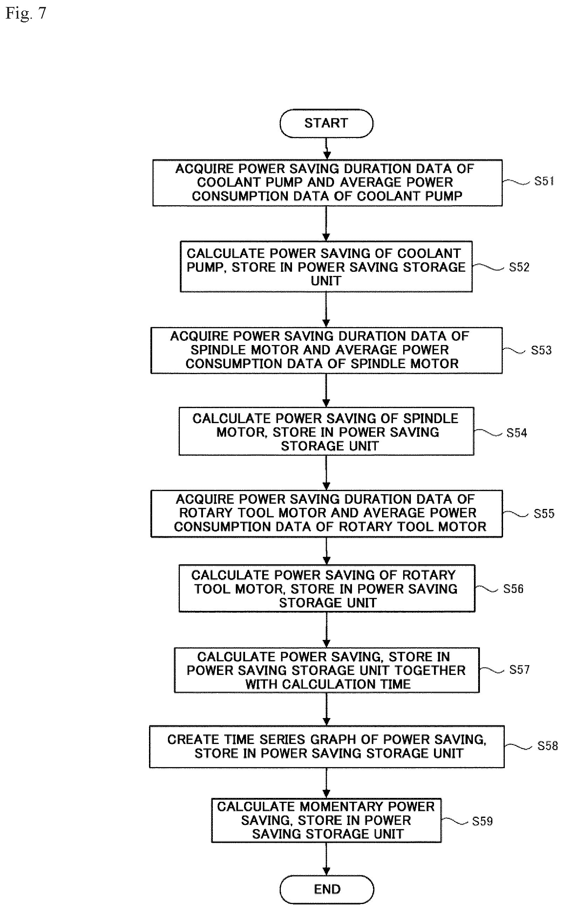

FIG. 7 is a flowchart showing an operation of the saving calculation unit 14 shown in FIG. 2. The operation shown in FIG. 7 is executed every 8 msec, for example, after switching on the power supply of the NC lathe 1 (see FIG. 1). Note, however, that the operation shown in FIG. 7 may be executed only when a request is issued by the display instruction unit 15. Moreover, the saving calculation unit 14 may execute only an operation necessary for the information requested by the display instruction unit 15.

As shown in FIG. 7, the saving calculation unit 14 acquires data indicating the duration that the coolant pump 7 has been in the power saving state from the saving time storage unit 221, and acquires the average power consumption data AD of the coolant pump 7 from the power consumption storage unit 222 (step S51). The saving calculation unit 14 then determines the cumulative duration by accumulating the duration that the coolant pump 7 has been in the power saving state, calculates the power saving of the coolant pump 7 by multiplying the average power consumption of the coolant pump 7, acquired from the average power consumption data AD, by the cumulative duration, and stores the calculated power saving in the power saving storage unit 223 (step S52).

Further, the saving calculation unit 14 acquires data indicating the duration that the spindle motor 42 has been in the power saving state from the saving time storage unit 221, and acquires the average power consumption data AD of the spindle motor 42 from the power consumption storage unit 222 (step S53). The saving calculation unit 14 then determines the cumulative duration by accumulating the duration that the spindle motor 42 has been in the power saving state, calculates the power saving of the spindle motor 42 by multiplying the average power consumption of the spindle motor 42, acquired from the average power consumption data AD, by the cumulative duration, and stores the calculated power saving in the power saving storage unit 223 (step S54).

Furthermore, the saving calculation unit 14 acquires data indicating the duration that the rotary tool motor 44 has been in the power saving state from the saving time storage unit 221, and acquires the average power consumption data AD of the rotary tool motor 44 from the power consumption storage unit 222 (step S55). The saving calculation unit 14 then determines the cumulative duration by accumulating the time that the rotary tool motor 44 has been in the power saving state, calculates the power saving of the rotary tool motor 44 by multiplying the average power consumption of the rotary tool motor 44, acquired from the average power consumption data AD, by the cumulative duration, and stores the calculated power saving in the power saving storage unit 223 (step S56). The power saving of the coolant pump 7, the power saving of the spindle motor 42, and the power saving of the rotary tool motor 44 each correspond to an example of the device-specific power saving.

Next, the saving calculation unit 14 calculates the power saving by adding together the respective calculated power savings of the coolant pump 7, the spindle motor 42, and the rotary tool motor 44, and stores the calculated power saving in the power saving storage unit 223 together with the calculation time (step S57). Steps S51 to S57 are an example of a power saving calculation step. Further, the graph creation unit 16 creates a time series graph that represents the transition of the power saving relative to the elapsed time after switching on the power supply of the NC lathe 1 using the elapsed time and the power saving as axes, and stores the created time series graph in the power saving storage unit 223 (step S58). As regards step S58, the request from the graph display instruction unit 153 is continuously executed by the graph creation unit 16 for as long as the graph display instruction unit 153 displays the time series graph on the display part 32, but when the time series graph is not displayed, step S58 is omitted. In addition, the saving calculation unit 14 calculates the momentary power saving, which is the power being saved at that point in time, by adding together the average power consumptions of the target electric devices received from the signal determination unit 13 as the target electric devices that have been in the power saving state over the last 8 msec. The saving calculation unit 14 then stores the calculated momentary power saving in the power saving storage unit 223 (step S59). Here, when past data already exist in the power saving storage unit 223, the saving calculation unit 14 stores the new data by overwriting the past data with the new data. Note that the saving calculation unit 14 may read the past data stored in the power saving storage unit 223, calculate the device-specific power savings and the power saving or update the time series graph by adding the information newly received from the signal determination unit 13 to the past data, and store the result in the power saving storage unit 223.

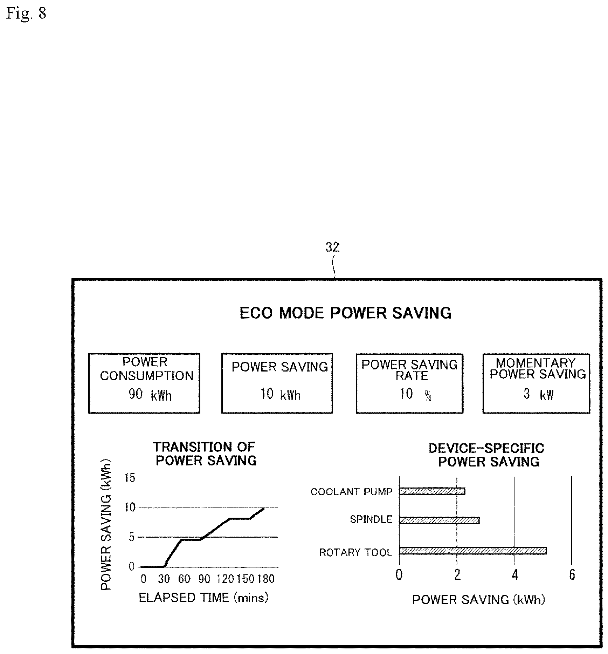

FIG. 8 is a view showing a display screen of the power saving and so on, which is displayed on the display part 32 in response to an instruction from the display instruction unit 15 shown in FIG. 2.

As described above, the display instruction unit 15 displays the information requested by the operator of the NC lathe 1 by performing an input operation on the operating part 31 on the display part 32. FIG. 8 shows an example of a screen displayed in a case where the operator performs an input operation to display the device-specific power savings, the power saving, the time series graph (the transition of the power saving), and the momentary power saving. These elements are displayed on the display part 32 by the device-specific power saving display instruction unit 151, the power saving display instruction unit 152, the graph display instruction unit 153, and the momentary power saving display instruction unit 154, respectively, using the information stored in the power saving storage unit 223 by the saving calculation unit 14. While these elements are displayed, the displayed content is updated at regular time intervals. As a result of these updates, the operator of the NC lathe 1 can check the power saving and the transition thereof in real time. FIG. 8 shows an example of a screen on which the device-specific power savings are disposed on the lower right side, the time series graph is disposed on the lower left side, the power saving is disposed second from the left on the upper side, and the momentary power saving is disposed on the upper right end. Furthermore, FIG. 8 shows an example of a screen on which the power consumption after switching on the power supply of the NC lathe 1 is disposed on the upper left end, and a power saving rate, which is a ratio of the amount of power it has been possible to save to the amount of power that would have been consumed in the normal mode, is disposed second from the right on the upper side. On the time series graph shown in FIG. 8, the power saving after switching on the power supply of the NC lathe 1 is shown on the graph, but instead, only a time specified by an input operation from the operator may be displayed as the time series graph. Moreover, the transition of the power consumption may be displayed as a time series graph in addition to the transition of the power saving, and it may be possible to switch between the time series graph of the transition of the power consumption and the time series graph of the transition of the power saving. Furthermore, the elapsed time used as the axis of the time series graph may be changed to another desired unit such as seconds or hours. In addition, the elapsed time used as the axis of the time series graph may be switched between the elapsed time (1 min, 2 mins, etc.) from a reference time and the actual time (10:00, 10:01, etc.).

In the NC lathe 1 described above, the cumulative duration of the power saving state is determined for each target electric device by accumulating the duration that each target electric device has been in the power saving state, and the device-specific power saving is computed by multiplying the cumulative duration by the average power consumption. The power saving is then calculated by adding together the device-specific power savings of the respective target electric devices, and therefore the power saving can be calculated accurately and easily. Moreover, since there is no need for data to be used as a comparison subject, there is no need to operate the NC lathe 1 in the normal mode and check the power consumption. The reason for this is that because the signal determination unit 13 ascertains the state information of the energization requirement signals from the energization signal switching unit 111 and the saving calculation unit 14 calculates the power saving using this state information, the power saving can be calculated as the difference between the power amount in the normal mode and the power amount in the ECO mode. In other words, the signal determination unit 13 may be said to create a state in which the NC lathe 1 is virtually operated in the normal mode. The saving calculation unit 14 may then be said to calculate the power saving by comparing the power amount in this state with the power amount in the ECO mode. As a result, the power saving can be calculated even when the NC lathe 1 is operated in the ECO mode from the start.

Furthermore, by setting the signal β0 and the signal β1 in the prohibited state on the condition that the macro program PR2 for performing the product discharge operation is being executed, energization of the coolant pump 7 and the spindle motor 42 is shut off, thereby preventing unnecessary power consumption. Similarly, by setting the signal β2 in the prohibited state on the condition that the macro program PR2 for selecting a tool other than the rotary tool is being executed, energization of the rotary tool motor 44 is shut off, thereby preventing unnecessary power consumption. Moreover, by displaying the momentary power saving, the operator of the NC lathe 1 can recognize the momentary power saving, i.e., the power saving substantially at that moment. Furthermore, by displaying the device-specific power savings, the operator can recognize the device-specific power savings, i.e., the power saving of each target electric device. In addition, by displaying the time series graph, the operator can recognize the relationship between the elapsed time and the power saving.

The present invention is not limited to the embodiment described above, and various amendments may be applied thereto within the scope set forth in the claims. For example, in this embodiment, an example in which the present invention is applied to the NC lathe 1 was described, but the present invention may be applied to another machine tool such as a machining center or a milling machine. Furthermore, in this embodiment, the power saving is calculated using the spindle motor 42, the rotary tool motor 44, and the coolant pump 7 as the target electric devices, but the power saving may be calculated using other electric devices as targets instead of some or all of these devices, and the power saving may also be calculated by adding other electric devices to the target electric devices of this embodiment. Moreover, the condition for switching between the energization required state and the energization non-required state and the condition for switching between the prohibited state and the permitted state may be changed as appropriate. In addition, the NC lathe 1 of this embodiment can be switched between the ECO mode and the normal mode, but instead, the mode may be made non-switchable and the ECO mode may be selected at all times.

Even constituent features that are included only in the modified examples described above may be applied to other modified examples.

## Claims

1. A machine tool having a plurality of electric devices (7, 42, 44) that consume power while energized, the machine tool comprising:
an energization signal switching unit (111) for switching an energization signal set for each of the electric devices between an energization required state in which energization of the electric device is required, and an energization non-required state in which energization is not required; a prohibition signal switching unit (112) for switching an energization prohibition signal set for each of the electric devices between a prohibited state in which energization of the electric device is prohibited, and a permitted state in which energization is permitted;
a signal determination unit (13) that determines whether or not each of the electric devices is in a power saving state in which the energization signal for the electric device is in the energization required state and the energization prohibition signal is in the prohibited state; **characterized in that** the machine tool further comprises
a saving calculation unit (14) that determines a cumulative duration of the power saving state by using state information of the energization signal for the electric device which is ascertained by the signal determination unit (13), computes a power amount when each of the electric devices is virtually operated as a device-specific power saving on the basis of the cumulative duration, and calculates a power saving by adding together the device-specific power savings.

2. The machine tool according to claim 1, wherein the signal determination unit (13) determines whether or not the power saving state is established for each of the electric devices by monitoring the energization signal and the energization prohibition signal.

3. The machine tool according to claim 1, wherein the prohibition signal switching unit (112) sets the energization prohibition signal in the prohibited state in relation to the electric device associated with a predetermined macro program (PR2) on condition that the predetermined macro program (PR2) is currently underway.

4. The machine tool according to claim 1, comprising a motor (42, 44) that serves as the electric device, wherein the prohibition signal switching unit (112) switches the energization prohibition signal to the prohibited state, in which energization for exciting the motor (42, 44) is prohibited, on condition that the motor (42, 44) is not rotating.

5. The machine tool according to claim 1, wherein the prohibition signal switching unit (112) switches the energization prohibition signal for the electric device to the prohibited state on condition that a product discharge operation is currently underway or a tool other than a rotary tool (6)has been selected.

6. The machine tool according to claim 1, comprising a spindle (5) having a chuck for gripping a workpiece, and a spindle motor (42) that serves as the electric device for rotating the spindle (5), wherein the prohibition signal switching unit (112) switches the energization prohibition signal for the spindle motor (42) to the prohibited state on condition that the spindle (5) is positioned in a predetermined position or the chuck is open.

7. The machine tool according to claim 1, comprising a power consumption storage unit (222) that stores, for each of the electric devices, an average power consumption per unit time while the electric device is energized, wherein the saving calculation unit (14) computes the device-specific power saving by multiplying the average power consumption by the cumulative duration.

8. The machine tool according to claim 7, comprising a momentary power saving display instruction unit (154) that displays, as a momentary power saving, a power obtained by adding together the average power consumptions of the electric devices determined by the signal determination unit (13) to be in the power saving state, among the plurality of electric devices (7, 42, 44).

9. The machine tool according to any one of claims 1 to 7, comprising a device-specific power saving display instruction unit (151) that displays, for each of the electric devices, the device-specific power saving computed by the saving calculation unit (14).

10. The machine tool according to any one of claims 1 to 7, comprising a graph display instruction unit (153) that displays a graph having the power saving calculated by the saving calculation unit (14) and the elapsed time as axes.

11. A method for calculating a power saving of a machine tool having a plurality of electric devices (7, 42, 44) that consume power while energized, the method comprising:
an energization signal detection step for detecting, for each of the electric devices, whether an energization signal is in an energization required state in which energization is required, or an energization non-required state in which energization is not required;
a prohibition signal detection step for detecting, for each of the electric devices, whether an energization prohibition signal is in a prohibited state in which energization is prohibited, or a permitted state in which energization is permitted;
a signal determination step for determining whether or not each of the electric devices is in a power saving state in which, in the energization signal detection step and the prohibition signal detection step, the energization signal and the energization prohibition signal for the electric device are respectively in the energization required state and the prohibited state; **characterized in that** the method further comprises
a saving calculation step for determining a cumulative duration of the power saving state by using state information of the energization signal for the electric device which is ascertained by the signal determination step, computing a power amount when each of the electric devices is virtually operated as a device-specific power saving on the basis of the cumulative duration, and calculating a power saving by adding together the device-specific power savings.

## Patentansprüche

1. Werkzeugmaschine mit einer Vielzahl von elektrischen Vorrichtungen (7, 42, 44), die im bestromten Zustand Leistung verbrauchen, wobei die Werkzeugmaschine umfasst:
eine Bestromungssignal-Umschalteinheit (111) zum Umschalten eines für jede der elektrischen Vorrichtungen festgelegten Bestromungssignals zwischen einem Bestromung-erforderlich-Zustand, in dem eine Bestromung der elektrischen Vorrichtung erforderlich ist, und einem Bestromung-nicht-erforderlich-Zustand, in dem eine Bestromung nicht erforderlich ist;
eine Sperrsignal-Umschalteinheit (112) zum Umschalten eines für jede der elektrischen Vorrichtungen festgelegten Bestromungssperrsignals zwischen einem gesperrten Zustand, in dem eine Bestromung der elektrischen Vorrichtung gesperrt ist, und einem freigegebenen Zustand, in dem eine Bestromung freigegeben ist;
eine Signalbestimmungseinheit (13), die bestimmt, ob sich jede der elektrischen Vorrichtungen in einem Energieeinsparzustand befindet oder nicht, in dem sich das Bestromungssignal für die elektrische Vorrichtung in dem Bestromung-erforderlich-Zustand befindet und sich das Bestromungssperrsignal in dem gesperrten Zustand befindet;
**dadurch gekennzeichnet, dass** die Werkzeugmaschine ferner umfasst:
eine Einsparungsberechnungseinheit (14), die eine kumulative Dauer des Energieeinsparzustands unter Verwendung von Zustandsinformationen des Bestromungssignals für die elektrische Vorrichtung bestimmt, die von der Signalbestimmungseinheit (13) festgestellt werden, auf Grundlage der kumulativen Dauer eine Leistungsmenge berechnet, wenn jede der elektrischen Vorrichtungen virtuell als eine vorrichtungsspezifische Energieeinsparung betrieben wird, und eine Energieeinsparung durch Addieren der vorrichtungsspezifischen Energieeinsparungen berechnet.

2. Werkzeugmaschine nach Anspruch 1, wobei die Signalbestimmungseinheit (13) durch Überwachen des Bestromungssignals und des Bestromungssperrsignals bestimmt, ob der Energieeinsparzustand für jede der elektrischen Vorrichtungen vorliegt oder nicht.

3. Werkzeugmaschine nach Anspruch 1, wobei die Sperrsignal-Umschalteinheit (112) das Bestromungssperrsignal in Bezug auf die elektrische Vorrichtung, die einem vorbestimmten Makroprogramm (PR2) zugeordnet ist, in den gesperrten Zustand versetzt, unter der Bedingung, dass das vorbestimmte Makroprogramm (PR2) derzeit läuft.

4. Werkzeugmaschine nach Anspruch 1, umfassend einen Motor (42, 44), der als die elektrische Vorrichtung dient, wobei die Sperrsignal-Umschalteinheit (112) das Bestromungssperrsignal in den gesperrten Zustand schaltet, in dem eine Bestromung zum Erregen des Motors (42, 44) gesperrt ist, unter der Bedingung, dass sich der Motor (42, 44) nicht dreht.

5. Werkzeugmaschine nach Anspruch 1, wobei die Sperrsignal-Umschalteinheit (112) das Bestromungssperrsignal für die elektrische Vorrichtung in den gesperrten Zustand schaltet, unter der Bedingung, dass derzeit ein Produktausgabevorgang läuft oder ein anderes Werkzeug als ein Drehwerkzeug (6) ausgewählt wurde.

6. Werkzeugmaschine nach Anspruch 1, umfassend eine Spindel (5) mit einem Spannfutter zum Greifen eines Werkstücks und einen Spindelmotor (42), der als die elektrische Vorrichtung zum Drehen der Spindel (5) dient, wobei die Sperrsignal-Umschalteinheit (112) das Bestromungssperrsignal für den Spindelmotor (42) in den gesperrten Zustand schaltet, unter der Bedingung, dass die Spindel (5) in einer vorbestimmten Position positioniert ist oder das Spannfutter geöffnet ist.

7. Werkzeugmaschine nach Anspruch 1, umfassend eine Leistungsaufnahme-Speichereinheit (222), die für jede der elektrischen Vorrichtungen eine durchschnittliche Leistungsaufnahme pro Zeiteinheit speichert, während die elektrische Vorrichtung bestromt ist, wobei die Einsparungsberechnungseinheit (14) die vorrichtungsspezifische Energieeinsparung berechnet, indem sie die durchschnittliche Leistungsaufnahme mit der kumulativen Dauer multipliziert.

8. Werkzeugmaschine nach Anspruch 7, umfassend eine Anzeigeanweisungseinheit (154) für eine momentane Energieeinsparung, die als momentane Energieeinsparung eine Leistung anzeigt, die durch Addition der durchschnittlichen Leistungsaufnahmen der elektrischen Vorrichtungen erhalten wird, die von der Signalbestimmungseinheit (13) unter der Vielzahl von elektrischen Vorrichtungen (7, 42, 44) als in dem Energieeinsparzustand befindlich bestimmt wurden.

9. Werkzeugmaschine nach einem der Ansprüche 1 bis 7, umfassend eine Anzeigeanweisungseinheit (151) für vorrichtungsspezifische Energieeinsparungen, die für jede der elektrischen Vorrichtungen die von der Einsparungsberechnungseinheit (14) berechnete vorrichtungsspezifische Energieeinsparung anzeigt.

10. Werkzeugmaschine nach einem der Ansprüche 1 bis 7, umfassend eine Grafikanzeigeanweisungseinheit (153), die eine Grafik anzeigt, deren Achsen die von der Einsparungsberechnungseinheit (14) berechnete Energieeinsparung und die verstrichene Zeit sind.

11. Verfahren zum Berechnen einer Energieeinsparung einer Werkzeugmaschine mit einer Vielzahl von elektrischen Vorrichtungen (7, 42, 44), die im bestromten Zustand Leistung verbrauchen, wobei das Verfahren umfasst:
einen Bestromungssignal-Erfassungsschritt, um für jede der elektrischen Vorrichtungen zu erfassen, ob sich ein Bestromungssignal in einem Bestromung-erforderlich-Zustand befindet, in dem eine Bestromung erforderlich ist, oder in einem Bestromung-nicht-erforderlich-Zustand befindet, in dem eine Bestromung nicht erforderlich ist;
einen Sperrsignal-Erfassungsschritt, um für jede der elektrischen Vorrichtungen zu erfassen, ob sich ein Bestromungssperrsignal in einem gesperrten Zustand befindet, in dem eine Bestromung gesperrt ist, oder in einem freigegebenen Zustand befindet, in dem eine Bestromung freigegeben ist;
einen Signalbestimmungsschritt zum Bestimmen, ob sich jede der elektrischen Vorrichtungen in einem Energieeinsparzustand befindet oder nicht, in dem im Bestromungssignal-Erfassungsschritt und im Sperrsignal-Erfassungsschritt das Bestromungssignal und das Bestromungssperrsignal für die elektrische Vorrichtung jeweils im Bestromung-erforderlich-Zustand und im gesperrten Zustand befinden;
**dadurch gekennzeichnet, dass** das Verfahren ferner umfasst:
einen Einsparungsberechnungsschritt zum Bestimmen einer kumulativen Dauer des Energieeinsparzustands unter Verwendung von Zustandsinformationen des für die elektrische Vorrichtung bestimmten Bestromungssignals, die durch den Signalbestimmungsschritt ermittelt wurden, zum Berechnen einer Leistungsmenge, wenn jede der elektrischen Vorrichtungen virtuell als eine vorrichtungsspezifische Energieeinsparung betrieben wird, auf Grundlage der kumulativen Dauer, und zum Berechnen einer Energieeinsparung durch Addition der vorrichtungsspezifischen Energieeinsparungen.

## Revendications

1. Machine-outil comportant une pluralité de dispositifs électriques (7, 42, 44) qui consomment de l'énergie lorsqu'ils sont sous tension, la machine-outil comprenant:
une unité de commutation de signal d'alimentation (111) destinée à commuter un signal d'alimentation défini pour chacun des dispositifs électriques entre un mode alimentation requise dans lequel l'alimentation du dispositif électrique est requise, et un mode alimentation non requise dans lequel l'alimentation n'est pas requise;
une unité de commutation de signal d'interdiction (112) destinée à commuter un signal d'interdiction d'alimentation défini pour chacun des dispositifs électriques entre un mode interdiction dans lequel l'alimentation du dispositif électrique est interdite, et un mode autorisation dans lequel l'alimentation est autorisée;
une unité de détermination de signal (13) qui détermine si chacun des dispositifs électriques se trouve ou non en mode économie d'énergie dans lequel le signal d'alimentation pour le dispositif électrique est en mode alimentation requis et le signal d'interdiction d'alimentation est en mode interdiction;
**caractérisée en ce que** la machine-outil comprend en outre une unité de calcul d'économie (14) qui détermine une durée cumulative du mode économie d'énergie en utilisant des informations d'état du signal d'alimentation pour le dispositif électrique qui sont déterminées par l'unité de détermination de signal (13), calcule une quantité d'énergie lorsque chacun des dispositifs électriques est virtuellement actionné en tant qu'économie d'énergie spécifique au dispositif sur la base de la durée cumulée, et calcule une économie d'énergie en additionnant les économies d'énergie spécifiques aux dispositifs.

2. Machine-outil selon la revendication 1, dans laquelle l'unité de détermination de signal (13) détermine si le mode économie d'énergie est établi ou non pour chacun des dispositifs électriques en surveillant le signal d'activation et le signal d'interdiction d'activation.

3. Machine-outil selon la revendication 1, dans laquelle l'unité de commutation de signal d'interdiction (112) place le signal d'interdiction d'alimentation en mode interdiction en ce qui concerne le dispositif électrique associé à un programme macro prédéterminé (PR2), à condition que le programme macro prédéterminé (PR2) soit en cours d'exécution.

4. Machine-outil selon la revendication 1, comprenant un moteur (42, 44) qui sert de dispositif électrique, dans laquelle l'unité de commutation de signal d'interdiction (112) commute le signal d'interdiction d'alimentation en mode interdiction, dans lequel l'alimentation destinée à exciter le moteur (42, 44) est interdite, à condition que le moteur (42, 44) ne tourne pas.

5. Machine-outil selon la revendication 1, dans laquelle l'unité de commutation de signal d'interdiction (112) commute le signal d'interdiction d'alimentation du dispositif électrique en mode interdiction à condition qu'une opération de déchargement de produit soit en cours ou qu'un outil autre qu'un outil rotatif (6) ait été sélectionné.

6. Machine-outil selon la revendication 1, comprenant une broche (5) comportant un mandrin pour saisir une pièce à usiner, et un moteur de broche (42) qui sert de dispositif électrique pour faire tourner la broche (5), dans laquelle l'unité de commutation de signal d'interdiction (112) commute le signal d'interdiction d'alimentation pour le moteur de broche (42) en mode interdiction à condition que la broche (5) soit positionnée dans une position prédéterminée ou que le mandrin soit ouvert.

7. Machine-outil selon la revendication 1, comprenant une unité de stockage de la consommation d'énergie (222) qui stocke, pour chacun des dispositifs électriques, une consommation d'énergie moyenne par unité de temps pendant que le dispositif électrique est alimenté, dans laquelle l'unité de calcul des économies (14) calcule les économies d'énergie spécifiques au dispositif en multipliant la consommation d'énergie moyenne par la durée cumulée.

8. Machine-outil selon la revendication 7, comprenant une unité d'instruction d'affichage de l'économie d'énergie instantanée (154) qui affiche, en tant qu'économie d'énergie instantanée, une puissance obtenue en additionnant les consommations d'énergie moyennes des dispositifs électriques déterminés par l'unité de détermination de signal (13) comme étant en mode économie d'énergie, parmi la pluralité de dispositifs électriques (7, 42, 44).

9. Machine-outil selon l'une quelconque des revendications 1 à 7, comprenant une unité d'instruction d'affichage des économies d'énergie spécifiques à un dispositif (151) qui affiche, pour chacun des dispositifs électriques, l'économie d'énergie spécifique au dispositif calculée par l'unité de calcul des économies (14).

10. Machine-outil selon l'une quelconque des revendications 1 à 7, comprenant une unité d'instruction d'affichage graphique (153) qui affiche un graphique ayant pour axes l'économie d'énergie calculée par l'unité de calcul d'économie (14) et le temps écoulé.

11. Procédé de calcul d'une économie d'énergie d'une machine-outil comportant une pluralité de dispositifs électriques (7, 42, 44) qui consomment de l'énergie lorsqu'ils sont sous tension, le procédé comprenant:
une étape de détection de signal de mise sous tension pour détecter, pour chacun des dispositifs électriques, si un signal de mise sous tension se trouve en mode de mise sous tension requise dans lequel la mise sous tension est requise, ou dans en mode de mise sous tension non requise dans lequel la mise sous tension n'est pas requise;
une étape de détection de signal d'interdiction pour détecter, pour chacun des dispositifs électriques, si un signal d'interdiction d'alimentation se trouve en mode interdiction dans lequel l'alimentation est interdite, ou dans un mode autorisation dans lequel l'alimentation est autorisée;
une étape de détermination de signal pour déterminer si chacun des dispositifs électriques se trouve ou non en mode économie d'énergie dans lequel, lors de l'étape de détection du signal d'activation et de l'étape de détection du signal d'interdiction, le signal d'activation et le signal d'interdiction d'activation pour le dispositif électrique se trouvent respectivement en mode activation requise et en mode interdiction;
**caractérisé en ce que** le procédé comprend en outre une étape de calcul d'économie d'énergie pour déterminer une durée cumulative du mode économie d'énergie en utilisant des informations d'état du signal d'alimentation pour le dispositif électrique qui sont établies par l'étape de détermination de signal, en calculant une quantité d'énergie lorsque chacun des dispositifs électriques est virtuellement mis en service en tant qu'économie d'énergie spécifique au dispositif sur la base de la durée cumulative, et en calculant une économie d'énergie en additionnant les économies d'énergie spécifiques aux dispositifs.
